# EUROPÄISCHE PATENTSCHRIFT

(11) **EP 2 247 771 B1**
(45) Veröffentlichungstag und Bekanntmachung des Hinweises auf die Patenterteilung: **26.07.2017**
(21) Anmeldenummer: 09701760.2
(22) Anmeldetag: 15.01.2009
(51) Int. Cl.: H01L 39/24, C23C 18/12

(54) **NASSCHEMISCHES VERFAHREN ZUR HERSTELLUNG EINES HOCHTEMPERATURSUPRALEITERS**
WET CHEMICAL METHOD FOR THE PRODUCTION OF A HIGH-TEMPERATURE SUPERCONDUCTOR
PROCÉDÉ CHIMIQUE HUMIDE POUR LA FABRICATION D'UN SUPRACONDUCTEUR HAUTE TEMPÉRATURE

(30) Priorität: 17.01.2008 DE 102008004818
(43) Veröffentlichungstag der Anmeldung: 10.11.2010
(73) Patentinhaber: BASF SE, 67056 Ludwigshafen am Rhein (DE)
(72) Erfinder: VAN DRIESSCHE, Isabel, 9250 Waasmunster (BE); VERMEIR, Pieter, 9160 Lokeren (BE); HOSTE, Serge, 9820 Merelbeke (BE); BÄCKER, Michael, 50670 Köln (DE)
(74) Vertreter: BASF IP Association
(86) Internationale Anmeldenummer: PCT/EP2009/000214
(87) Internationale Veröffentlichungsnummer: WO 2009/090062

(56) Entgegenhaltungen:
- EP-A- 1 850 402
- DE-A1-102004 041 053
- US-A1- 2002 139 960
- MCINTYRE P C ET AL: "Effect of growth conditions on the properties and morphology of chemically derived epitaxial thin films of Ba2YCu3O7-x on (001) LaAlO3" JOURNAL OF APPLIED PHYSICS, AMERICAN INSTITUTE OF PHYSICS. NEW YORK, US, Bd. 4, Nr. 71, 15. Februar 1992 (1992-02-15), Seiten 1868-1877, XP002079853 ISSN: 0021-8979
- MCINTYRE P C ET AL: "METALORGANIC DEPOSITION OF HIGH-JCBA2YCU3O7-X THIN FILMS FROM TRIFLUOROACETATE PRECURSORS ONTO (100) SRTIO3" JOURNAL OF APPLIED PHYSICS, AMERICAN INSTITUTE OF PHYSICS. NEW YORK, US, Bd. 68, Nr. 8, 15. Oktober 1990 (1990-10-15), Seiten 4183-4187, XP001032053 ISSN: 0021-8979

## Beschreibung

Die Erfindung betrifft ein Verfahren zur nasschemischen Herstellung eines texturierten Hochtemperatursupraleiters (HTSL) auf einem vorzugsweise bandförmigen Träger. Dazu wird zunächst eine HTSL-Precursorlösung durch Auflösen von RE-, Ba-, und Cu-Salzen hergestellt. RE steht für ein Elementsymbol der Seltenen Erden, z.B. Y (= Yttrium). Die HTSL-Precursorlösung wird anschließend auf einen vorzugsweise texturierten Träger aufgebracht und vorzugsweise zumindest angetrocknet. Bei der Trocknung entsteht eine amorphe Schicht aus den Salzen. Bei der anschließenden Wärmebehandlung werden die Salze in einen texturierten Cupratsupraleiter überführt.

Texturierte HTSL auf einem Träger werden auch als Dünnschicht-HTSL bezeichnet und unterscheiden sich von den üblichen nach dem "Powder in Tube"-Verfahren hergestellten Multifilament HTSL und auch von durch Vorpressen und anschließendem Sintern von HTSL-Pulver hergestellten HTSL insbesondere dadurch, dass die supraleitende Querschnittsfläche der Dünnschicht-HTSL deutlich kleiner ist. Deshalb ist es für Dünnschicht-HTSL essentiell, dass die HTSL-Schicht auf dem Träger eine möglichst hohe kritische Stromdichte hat. Die kritische Stromdichte hängt ganz wesentlich davon ab, dass der HTSL auf dem Träger, d.h. die HTSL-Schicht, möglichst keine Verwerfungen oder dergleichen aufweist und somit eine möglichst gleichmäßige Textur hat, also texturiert ist. Die Textur einer HTSL-Schicht kann z.B. mittels Röntgendiffraktometrie bestimmt werden.

Bei der nasschemischen Herstellung von Dünnschicht-HTSL muss die HTSL-Schicht deshalb möglichst texturiert auf dem Träger abgeschieden werden. Dies wird u.a. von der Zusammensetzung der Precursorlösung beeinflusst. Daher wird bei der Herstellung der HTSL-Precursorlösung neben mindestens einem organischen Salz und/oder einem organischen Lösungsmittel und/oder einem organischen Komplexbildner in der Regel Trifluoressigsäure (TFA) verwendet. Wird der HTSL-Precursorlösung keine Trifluoressigsäure (TFA) zugegeben, entsteht bei der späteren Wärmebehandlung Barium-Carbonat. Barium-Carbonat ist chemisch sehr stabil. Deswegen steht als Carbonat gebundenes Barium nicht für die Bildung des REBa₂Cu₃Oₓ-Supraleiters zur Verfügung und behindert an den Korngrenzen den Stromtransport. Verwendet man jedoch für die Salze Lösungsmittel mit Trifluoressigsäure, entsteht anstelle von Barium-Carbonat Bariumfluorid, das während der Wärmebehandlung mit Wasserdampf zu Barium-Oxid und zu Flusssäure reagiert. Problematisch ist dabei, dass der Wasserdampf zunächst in die HTSL-Precursorschicht eindiffundieren und die Flusssäure aus der Schicht wieder herausdiffundieren muss. Deshalb können nur vergleichsweise dünne Schichten aufgewachsen werden. Zudem entstehen durch die Diffusion Poren in der HTSL-Schicht. Ein weiterer Nachteil bei der Verwendung von TFA ist, dass die entstehende Flusssäure sehr giftig und auch in Verdünnung noch ätzend ist.

Gemäß der DE 10 2004 041 053 B4 kann die Flusssäureproblematik durch eine Mehrfachbeschichtung verringert werden, bei der zunächst eine fluorfreie und als oberste Schicht eine fluorhaltige d.h. TFA-basierte Precursorlösung auf den Träger aufgebracht wird. Das in der obersten Schicht enthaltene Fluor genügt, damit auch in der darunterliegenden fluorfreien Schicht während der Wärmebehandlung keine nennenswerten Mengen an Barium-Carbonat entstehen.

Verfahren zur Herstellung von HTSL-Pulver, bei denen keine TFA verwendet wird, sind zwar z.B. aus einem Aufsatz von Grader et al. (Physica C 290 (1997), 70-88) bekannt, jedoch kann mit keinem dieser "TFA-freien" Verfahren eine texturierte HTSL-Schicht auf einem Träger abgeschieden werden.

Der Erfindung liegt die Aufgabe zugrunde, ein Verfahren zur nasschemischen Herstellung eines texturierten HTSL auf einem Träger ohne Verwendung fluorhaltiger Lösungsmittel bereitzustellen.

Diese Aufgabe ist durch ein Verfahren nach dem Anspruch 1 gelöst. Bei der Wärmebehandlung der Precursorschicht werden zunächst die Anionen der Salze zersetzt. Dabei entstehen Barium-Carbonat, Kupferoxid und ein Oxid der verwendeten Seltenen Erde, z.B. Yttriumoxid (Y₂O₃). Anschließend wird der Precursor auf eine Temperatur Tₛ erwärmt im einen Bereich, bei dem die Precursorschicht zumindest partiell aufschmilzt und die unterhalb der Temperatur ist, bei der nicht supraleitendes RE₂BaCuOₓ (z.B. Y₂BaCuO₅) entsteht. D.h. es entsteht in einer binären Reaktion aus Barium-Carbonat und Kupferoxid eine zumindest partielle Schmelze. Vorzugsweise wird die Temperatur Tₛ so gewählt, dass eine vollständige Barium-Carbonat / Kupferoxid Schmelze entsteht. Die Temperatur Tₛ ist abhängig von der Atmosphäre in dem verwendeten Ofen, insbesondere von deren Sauerstoffgehalt, dem verwendeten Seltenerdmetall und der Stöchiometrie der Metalle in der Schmelze. Ist in dem Ofen z.B. eine Stickstoffatmosphäre, wird als Seltenerdmetall Yttrium benutzt (RE=Y) und ist das Verhältnis von Y:Ba:Cu wie 1:2:3, dann beträgt Tₛ vorzugsweise etwa 780°C (partielle Schmelze ab etwa 620°C, Bildung von Y₂BaCuOₓ ab etwa 825°C, entsprechend etwa 620°C ≤ Tₛ ≤ 825°C). Ist in dem Ofen z.B. Luft (mit RE=Y, Y:Ba:Cu wie 1:2:3), dann beträgt Tₛ vorzugsweise etwa 900°C (möglich etwa 780°C ≤ Tₛ ≤ 915°C). Ist in dem Ofen z.B. reiner Sauerstoff (mit RE=_{Y}, Y:Ba:Cu wie 1:2:3), dann beträgt Tₛ vorzugsweise etwa 926°C (möglich etwa 810°C ≤ Tₛ ≤ 938°C).

Bei Verwendung von Neodym als Seltenerdmetall d.h. RE=Nd müssen die Temperaturen etwas größer gewählt werden.

Durch die beschriebene Temperaturwahl kann bei der Herstellung der HTSL-Precursorlösung auf TFA und andere fluorhaltige Zusätze verzichtet werden, d.h. die HTSL-Precursorlösung kann TFA frei sein, weil das BaCO₃ in der Schmelze in der Gegenwart von CuO instabil ist und zu Barium-Oxid (BaO) und Kohlendioxid (CO₂) zerfällt. Dies ist überraschend, denn bisher ging die Fachwelt davon aus, dass sich BaCO₃ erst bei 1450°C zersetzt (vgl. Handbook of Chemistry and Physics, 60. Ed., Chemical Rubber Company, 1980).

Das durch den Zerfall des BaCO₃ entstandene CO₂ gast aus und das verbleibende BaO reagiert mit dem CuO und dem Seltenerdoxid (z.B. Y₂O₃) zu REBa₂Cu₃Oₓ (z.B. YBa₂Cu₃Ox, auch YBCO genannt). Das REBa₂Cu₃Oₓ (z.B. YBCO) kristallisiert auf dem Träger aus, wobei ein Texturübertrag von der obersten (Puffer-) Schicht des Trägers auf die REBa₂Cu₃Oₓ-Schicht erfolgt.

Als Lösungsmittel zur Herstellung der HTSL-Precursorlösung wird vorzugsweise Wasser verwendet. Das Wasser kann mit Essigsäure angesäuert werden.

Bevorzugt wird der HTSL-Precursorlösung Tri-Ethanolamin (TEA) und/oder Ethylendiamintetraacetat (EDTA) zugegeben. TEA und EDTA stabilisieren als Komplexbildner beim Antrocknen der HTSL-Precursorlösung die Ionen in der HTSL-Precursorlösung.

Als Salze bei der Herstellung der HTSL-Precursorlösung können insbesondere Nitrate, Tartrate, Zitrate und/oder bevorzugt Acetate verwendet werden. Diese lassen sich leicht handhaben und die Anionen dieser Salze können durch Wärmeanwendung zersetzt werden.

Die Salze sind bei der Herstellung der HTSL-Precursorlösung vorzugsweise so zu dosieren, dass RE:Ba:Cu wie 1:1,5-2,5:2,5-4 bevorzugt, wie 1:1,5-2:3-3,5.

Wenn der HTSL-Precursorlösung oxidische Nanopartikel zugegeben werden, bilden diese in dem späteren HTSL sogenannte Pinningzentren für magnetische Flussschläuche. Dadurch kann die kritische Stromdichte erhöht werden. Der gleiche Effekt kann durch Zugabe von weiteren Metallsalzen erzielt werden.

Die Precursorlösung hat vorzugsweise einen pH-Wert zwischen 3 und 9, insbesondere etwa pH = 6,75.

Nachdem die HTSL-Precursorlösung auf den Träger aufgebracht wurde, wird ihre Viskosität bevorzugt auf etwa 1mPas bis etwa 30mPas besonders bevorzugt auf etwa 10mPas eingestellt werden.

Bei der Wärmebehandlung wird die Temperatur, bei der Bariumoxid und Kupferoxid eine Schmelze bilden aber kein RE₂BaCuOₓ entsteht, vorzugsweise für mindestens 25 Minuten beibehalten. Anschließend kann der HTSL auf eine Temperatur Tₐ zwischen etwa 380°C und etwa 550°C vorzugsweise ca. 400°C abgekühlt werden. Diese Temperatur wird bevorzugt mindestens 20 Minuten etwa konstant gehalten.

Während der HTSL-Precursor bei der Temperatur Tₛ zu REBa₂Cu₃Oₓ reagiert, hat die Atmosphäre in dem verwendeten Ofen vorzugsweise einen Sauerstoffgehalt kleiner 20% besonders bevorzugt kleiner 5%. Vorzugsweise wird der HTSL erst wenn er abkühlt zur Beladung mit Sauerstoff einer Atmosphäre von mindestens 50%, vorzugsweise 100% Sauerstoff ausgesetzt, z.B. wenn der Ofen auf die Temperatur Tₐ abgekühlt ist.

Als Träger wird üblicherweise ein Metallband mit mindestens einer keramischen Pufferschicht, z.B. aus Lanthanzirkonat, Ceroxid oder Strontiumtitanat, oder auch ein rein keramischer Träger, z.B. aus Strontiumtitanat oder Lanthanaluminat, verwendet. Bevorzugt ist der Träger texturiert, d.h. er hat eine texturierte Oberfläche auf die der HTSL abgeschieden wird, wobei ein Texturübertrag von dem Träger auf den HTSL erfolgt.

Selbstverständlich können mehrere HTSL-Precursorschichten auf den Träger aufgebracht und dann wärmebehandelt werden. Ebenso kann auch auf eine HTSL-Schicht eine weitere HTSL-Schicht aufgebracht werden.

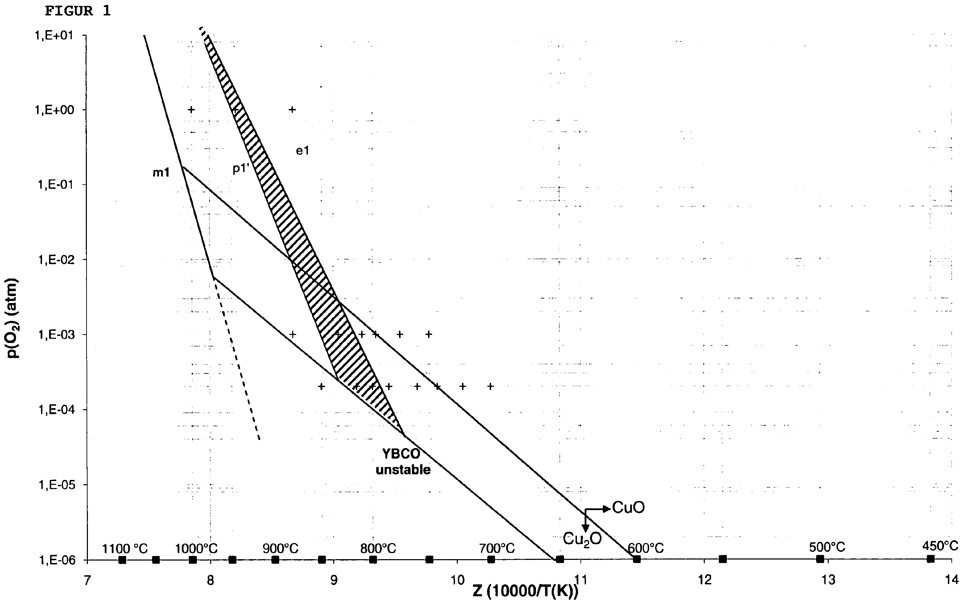

Anhand der nachfolgenden Beispiele und der einzigen Figur wird die Erfindung nochmals dargestellt:

### Beispiel 1:

Durch Kochen im Rückfluss wurden Y-, Ba- und Cu-Acetat (Y:Ba:Cu wie 1:2:3) in mit Essigsäure versetzem Wassser aufgelöst. Der so hergestellten HTSL-Precursorlösung wurde Tri-Ethanolamin (TEA) als Komplexbildner zugegeben. Das Verhältnis der Summe der Metalle (Y, Ba, Cu) zu TEA betrug 1:2,5. Durch Zugabe von Ammoniak (etwa 25 Gew.-%) wurde der pH-Wert auf etwa 6,75 eingestellt. Die HTSL-Precursorlösung war klar und blau. Sie wurde bei etwa 60°C auf eine Viskosität von etwa 9mPas eingedampft und anschließend auf einen gereinigten und entfetteten Träger aus poliertem (100) SrTiO₃ durch Eintauchen des Trägers in die HTSL-Precurlösung aufgetragen (Ausziehgeschwindigkeit etwa 50 mm/min). Der Träger mit der HTSL-Precursorlösung wurde etwa 1h bei 60°C angetrocknet. Danach war die HTSL-Precursorlösung gelartig. Die anschließende Wärmebehandlung erfolgte in einem Ofen. Der Ofen mit den HTSL-PrecursorProben wurde mit 10°C/min von Raumtemperatur auf Tₛ = 815°C (möglich 800°C - 835°C) erwärmt. In dem Ofen war eine N₂-Atmoshäre mit einem O₂-Anteil von etwa 200 ppm. Nach ca. 150 min wurde die Ofentemperatur auf etwa 525°C eingestellt und die Ofenatmosphäre gegen O₂ ausgetauscht. Der Ofen wurde auf etwa 400°C abgekühlt und diese Temperatur wurde für etwa 30min gehalten. Nach ca. 5 Stunden wurde der Ofen abgeschaltet und nach dem Abkühlen auf Raumtemperatur wurden die HTSL-Proben entnommen. Die Charakterisierung der Proben ergab T_{c} = 92K mit ΔT_{c} = 5K und J_{c} = 1,87 MA/cm².

### Beispiel 2:

Eine HTSL-Precursorlösung wurde gemäß Beispiel 1 hergestellt, auf einen Träger aufgebracht und angetrocknet. Auch die anschließende Wärmebehandlung erfolgte analog, jedoch war in dem Ofen mit den HTSL-Precursorproben eine N₂-Atmoshäre mit einem O₂-Anteil von 1000 ppm. Der Ofen wurde mit 10°C/min von Raumtemperatur auf Tₛ = 838°C (möglich etwa 810°C - etwa 890°C) erwärmt. Etwa 150 min nach Erreichen von Tₛ wurde die Ofentemperatur auf etwa 525°C abgesenkt und die Ofenatmosphäre gegen O₂ ausgetauscht. Der Ofen wurde auf etwa 400°C abgekühlt und diese Temperatur wurde für etwa 5h gehalten. Danach wurde der Ofen abgeschaltet und nach dem Abkühlen auf Raumtemperatur wurden die HTSL-Proben entnommen. Die Charakterisierung der Proben ergab T_{c} = 92K mit ΔT_{c} = 2K und J_{c} = 1,28 MA/cm².

### Beispiel 3:

Durch Kochen im Rückfluss (1h, 90°C) wurden Y-, Ba- und Cu-Acetat (Y:Ba:Cu wie 1:2:3) in Wassser mit 15Vol% Essigsäure aufgelöst. Anschließend wurde durch Zugabe von ca. 25 Gew.% Ammoniak der pH-Wert der HTSL-Precursorlösung auf 6 eingestellt. Als Metallkomplexbildner wurde TEA zugegeben, wobei das Verhältnis der Summe der Metallionen (Y, Ba, Cu) zu TEA wie 1:0,5 war. Die HTSL-Precursorlösung war klar, blau und hatte einen pH von 6,2. Sie wurde anschließend auf einen entfetteten Träger aus poliertem (100) SrTiO₃ durch Eintauchen des Trägers in die HTSL-Precursorlösung aufgetragen (Ausziehgeschwindigkeit etwa 50 mm/min). Die HTSL-Precursorlösung auf dem Träger wurde etwa 1 h bei 60°C angetrocknet. Die anschließende Wärmebehandlung erfolgte in einem Ofen mit N₂-Atmosphäre und 200ppm O₂. Der Ofen wurde mit der Probe um ca. 10°C min⁻¹ auf 815°C erwärmt. Die Endtemperatur wurde etwa 150min gehalten. Anschließend wurde der Ofen auf eine Temperatur von 525°C abgekühlt und die Atmosphäre gegen O₂ ausgetauscht. Der Ofen wurde auf etwa 400°C abgekühlt und diese Temperatur wurde für etwa 5h gehalten. Danach wurde der Ofen abgeschaltet und nach dem Abkühlen auf Raumtemperatur wurden die HTSL-Proben entnommen. Die Charakterisierung der Proben ergab T_{c} = 92K mit ΔT_{c} = 4K und J_{c} = 0,89 MA/cm².

### Beispiel 4:

Eine HTSL-Precursorlösung wurde gemäß Beispiel 3 hergestellt, jedoch wurde anstelle von TEA Ethylendiamintetraacetat (EDTA) zugegeben, wobei das Verhältnis der Summe der Metallionen (Y, Ba, Cu) zu EDTA wie 1:0,5 war. Die Precursorlösung wurde wie in Beispiel 3 auf einen SrTiO₃-Träger aufgebracht und wärmebehandelt. Die Charakterisierung der Proben ergab T_{c} = 92K mit ΔT_{c} = 4K und J_{c} = 1,07 MA/cm².

### Beispiel 5:

Zu einer wässrigen Lösung von Nd-, Ba- und Cu-Nitrat (Nd:Ba:Cu wie 1:2:3) mit einer totalen Konzentration von 0,6M wurde verdünnte wässrige Zitronensäure (1,8M) unter Rühren an Luft zugegeben. Mit wässriger Ammoniumlösung wurde der pH auf 6 eingestellt um ein Ausfällen der Metallhydroxide und eine Rekristallisation während der nachfolgenden Schritte zu verhindern. Die HTSL-Precursorlösung wurde durch Eintauchen eines polierten (100) und entfetteten SrTiO₃-Trägers auf diesen aufgetragen (Ausziehgeschwindigkeit etwa 170mm/min). Die HTSL-Precursorlösung auf dem Träger wurde in einem staubfreien Ofen über mehrere Stunden 60°C ausgesetzt, bis die Konsistenz der HTSL-Precursorlösung bzw. -schicht gelartig war. Anschließend erfolgte eine Wärmebehandlung zur Erzeugung eines HTSL. Dazu wurde der Träger in einem Ofen mit 1°C/min auf zunächst 500°C und dann mit 5°C/min auf 940°C erwärmt. In dem Ofen war eine Argon (Ar) Atmosphäre mit 1% O₂. Anschließend wurde die entstandene NdBa₂Cu₃Oₓ-Schicht bei 450°C für 5h in einer O₂-Atmosphäre geglüht und dadurch mit Sauerstoff beladen. Die Charakterisierung der Proben ergab T_{c} = 89K mit ΔT_{c} = 10K und J_{c} = 0,3 MA/cm². Eine Untersuchung der HTSL-Schicht mit einem Rasterkraftmikroskop (AFM) ergab eine Schichtdicke von etwa 1µm. Das vergleichsweise langsame Aufheizen auf zunächst 500°C und dann auf 940°C war notwendig, damit sich in der HTSL-Precursorschicht keine Risse bilden.

### Beispiel 6:

Wie in Beispiel 1 wurde eine HTSL-Precursolösung hergestellt, aufgetragen, angetrocknet und wärmebehandelt. Jedoch wurde die Probe bis auf 850°C erwärmt. Bei diesem Versuch entstand kein YBCO, sondern nicht supraleitendes Y₂BaCuO₅, welches mittels Rasterelektronenmikroskopie anhand seiner charakteristischen nadelartigen Struktur identifiziert wurde.

### Beispiel 7:

Wie in Beispiel 1 wurde eine HTSL-Precursolösung hergestellt, auf einen Träger aufgetragen, angetrocknet und wärmebehandelt. Jedoch war in dem Ofen eine N₂-Atmosphäre mit 1000ppm O₂ und die Probe wurde bis auf 880°C erwärmt. Bei diesem Versuch entstand kein YBCO, sondern nicht supraleitendes Y₂BaCuO₅, welches mittels Rasterelektronenmikroskopie anhand seiner charakteristischen nadelartigen Struktur identifiziert wurde.

### Figur 1:

In der einzigen Figur ist der Sauerstoffgehalt der Ofenatmosphäre beim Erwärmen von Proben einer Versuchsreihe auf ihre jeweilige maximale Temperatur bei der Wärmebehandlung gegen die entsprechende maximale Temperatur aufgetragen. Jede Probe entspricht einem Kreuz. Die Träger der Proben wurden gemäß Beispiel 1 mit einer HTSL-Precursorlösung beschichtet. Nach der Trockung der HTSL-Precursorlösung erfolgte eine Wärmebehandlung in einem Ofen mit einer N₂-Atmosphäre deren Sauerstoffgehalt von Probe zu Probe variiert wurde. Der Ofen wurde mit den Proben um ca. 10°C min⁻¹ auf die jeweilige Maximaltemperatur erwärmt. Diese Temperatur wurde ca. 150 min gehalten. Das Abkühlen und Beladen der Proben mit Sauerstoff erfolgte gemäß Beispiel 1. Nur die Proben, deren Kreuze innerhalb des schraffierten Bereichs liegen, sind hochtemperatursupraleitend. Links des schraffierten Bereichs bildete sich Y₂BaCuO₅. Rechts des schraffierten Bereichs erfolgte keine binäre Reaktion von BaCO₃ mit CuO unter Bildung einer Schmelze. Das Barium-Carbonat hat sich zersetzt und stand somit nicht zur Bildung von YBa₂Cu₃Oₓ zur Verfügung.

## Patentansprüche

1. Verfahren zur nasschemischen Herstellung einer texturierten HTSL-Schicht auf einem Träger, dessen oberste Schicht texturiert ist, mit den Schritten:
a) Herstellen einer HTSL-Precursorlösung durch Auflösen von RE-, Ba- und Cu-Salzen, wobei RE für ein Elementsymbol der seltenen Erden steht,
b) Aufbringen der HTSL-Precursorlösung als HTSL-Precursorschicht auf den Träger.
c) Wärmebehandlung
**dadurch gekennzeichnet,**
**dass** die HTSL-Precursorlösung fluorfrei ist,
**dass** während der Wärmebehandlung die HTSL-Precursorschicht zunächst über eine Temperatur T₂ oberhalb der Zersetzungstemperaturen der Anionen der Salze erwärmt wird um Barium-Carbonat und Kupferoxid zu erzeugen,
und **dass** die HTSL-Precusorschicht anschließend auf eine Temperatur Tₛ erwärmt wird, bei der das Barium-carbonat und das Kupferoxid in einer binären Reaktion eine zumindest partielle Schmelze bilden und die unter der Temperatur liegt, bei der RE₂BaCuOₓ gebildet wird.

2. Verfahren nach Anspruch 1, **dadurch gekennzeichnet, dass** beim Herstellen der HTSL-Precursorlösung Wasser als Lösungsmittel verwendet wird.

3. Verfahren nach Anspruch 1 oder 2, **dadurch gekennzeichnet, dass** der HTSL-Precursorlösung ein Amin, insbesondere Tri-Ethanolamin oder Ethylendiamintetraacetat, zugegeben wird.

4. Verfahren nach einem der Ansprüche 1 bis 3, **dadurch gekennzeichnet, dass** als Salze Nitrate, Tartrate oder Citrate, insbesondere Acetate, verwendet werden.

5. Verfahren nach einem der Ansprüche 1 bis 4, **dadurch gekennzeichnet, dass** das Verhältnis von RE:Ba:Cu in der HTSL-Precursorlösung 1:1,5-2,5:2,5-4 beträgt.

6. Verfahren nach einem der Ansprüche 1 bis 5, **dadurch gekennzeichnet, dass** der HTSL-Precursorlösung oxidische Nanopartikel oder weitere Metallsalze zugesetzt werden.

7. verfahren nach einem der Ansprüche 1 bis 6, **dadurch gekennzeichnet, dass** zur Wärmebehandlung der HTSL-Precursorschicht letztere
d) mindestens 25 Minuten der Temperatur Tₛ ausgesetzt wird, und dann
e) auf eine Temperatur Tₛ zwischen ca. 380°C und 550°C, vorzugsweise ca. 400°C abgekühlt wird und diese Temperatur Tₐ ± 20° mindestens 20 Minuten konstant gehalten wird.

8. Verfahren nach Anspruch 7, **dadurch gekennzeichnet, dass** die HTSL-Precursorschicht während sie der Temperatur Tₛ ausgesetzt wird in einer Atmosphäre mit einem Sauerstoffgehalt <20% ist.

9. verfahren nach Anspruch 7 oder 8, **dadurch gekennzeichnet, dass** die HTSL-Precursorschicht während sie der Temperatur Tₐ ausgesetzt wird in einer Atmosphäre mit einem Sauerstoffgehalt von mindestens 50% oder vorzugsweise in einer Atmosphäre aus Sauerstoff ist.

10. Verfahren nach einem der Ansprüche 1 bis 9, **dadurch gekennzeichnet, dass** der pH-Wert der HTSL-Precursorlösung auf einen Wert zwischen 3 und 9 eingestellt wird.

11. Verfahren nach einem der Ansprüche 1 bis 10, **dadurch gekennzeichnet, dass** die HTSL-Precursorlösung, nachdem sie auf den Träger aufgebracht wurde, auf eine Viskosität von etwa 1mPas bis etwa 30mPas eingestellt wird.

12. Verfahren nach einem der Ansprüche 1 bis 11, **dadurch gekennzeichnet, dass** zwei oder mehr Schichten der HTSL-Precursorlösung auf den Träger aufgebracht werden.

13. Verfahren nach einem der Ansprüche 1 bis 12, **dadurch gekennzeichnet, dass** die HTSL-Precursorschicht vor der Erwärmung auf die Temperatur T_{z} zumindest angetrocknet wird.

14. Verfahren nach einem der Ansprüche 1 bis 13, **dadurch gekennzeichnet, dass** zur Herstellung der HTSL-Precursorlösung mindestens ein organisches Salz und/oder ein organisches Lösungsmittel und/oder ein organischer Komplexbildner verwendet werden, um durch Zersetzung der Salze Barium-Carbonat und Kupferoxid zu bilden, welche auf eine Temperatur Tₛ erwärmt werden, bei der aus dem Barium-Carbonat und dem Kupferoxid eine zumindest partielle Schmelze entsteht, in der das Barium-Carbonat zu Bariumoxid und Kohlendioxid zerfällt.

## Claims

1. A process for the wet-chemical production of a textured HTSL layer on a support, whose uppermost layer is textured, which comprises the steps:
a) production of an HTSL precursor solution by dissolution of RE, Ba and Cu salts, where RE is an element symbol for the rare earths,
b) application of the HTSL precursor solution as HTSL precursor layer to the support,
c) heat treatment,
wherein
the HTSL precursor solution is fluorine-free,
the HTSL precursor layer is, during heat treatment, firstly heated over a temperature T_{z} above the decomposition temperatures of the anions of the salts in order to produce barium carbonate and copper oxide,
and the HTSL precursor layer is subsequently heated to a temperature Tₛ at which the barium carbonate and the copper oxide form an at least partial melt in a binary reaction and which is below the temperature at which RE₂BaCuOₓ is formed.

2. The process according to claim 1, wherein water is used as solvent in the production of the HTSL precursor solution.

3. The process according to claim 1 or 2, wherein an amine, in particular triethanolamine or ethylenediaminetetraacetate, is added to the HTSL precursor solution.

4. The process according to any of claims 1 to 3, wherein nitrates, tartrates or citrates, in particular acetates, are used as salts.

5. The process according to any of claims 1 to 4, wherein the ratio of RE:Ba:Cu in the HTSL precursor solution is 1:1.5-2.5:2.5-4.

6. The process according to any of claims 1 to 5, wherein oxidic nanoparticles or further metal salts are added to the HTSL precursor solution.

7. The process according to any of claims 1 to 6, wherein, for the heat treatment of the HTSL precursor layer, the latter is
d) subjected to the temperature Tₛ for at least 25 minutes and is then
e) cooled to a temperature Tₐ in the range from about 380°C to 550°C, preferably about 400°C, and this temperature Tₐ ± 20° is kept constant for at least 20 minutes.

8. The process according to claim 7, wherein the HTSL precursor layer is in an atmosphere having an oxygen content of <20% while it is subjected to the temperature Tₛ.

9. The process according to claim 7 or 8, wherein the HTSL precursor layer is in an atmosphere having an oxygen content of at least 50% or preferably in an atmosphere of oxygen while it is subjected to the temperature Tₐ.

10. The process according to any of claims 1 to 9, wherein the pH of the HTSL precursor solution is set to a value in the range from 3 to 9.

11. The process according to any of claims 1 to 10, wherein the HTSL precursor solution is set to a viscosity of from about 1 mPas to about 30 mPas after it has been applied to the support.

12. The process according to any of claims 1 to 11, wherein two or more layers of the HTSL precursor solution are applied to the support.

13. The process according to any of claims 1 to 12, wherein the HTSL precursor layer is at least partially dried before being heated to the temperature T_{z}.

14. The process according to any of claims 1 to 13, wherein at least one organic salt and/or organic solvent and/or an organic complexing agent are used for producing the HTSL precursor solution in order to decompose the salts to form barium carbonate and copper oxide which are heated to a temperature Tₛ at which the barium carbonate and the copper oxide form an at least partial melt in which the barium carbonate decomposes into barium oxide and carbon dioxide.

## Revendications

1. Procédé de fabrication chimique humide d'une couche HTSL texturée sur un support, dont la couche supérieure est texturée, comprenant les étapes suivantes :
a) la fabrication d'une solution de précurseur d'HTSL par dissolution de sels de RE, Ba et Cu, RE représentant le symbole d'un élément des terres rares,
b) l'application de la solution de précurseur d'HTSL en tant que couche de précurseur d'HTSL sur le support,
c) le traitement thermique,
**caractérisé en ce que**
la solution de précurseur d'HTSL est exempte de fluor, **en ce que**, pendant le traitement thermique, la couche de précurseur d'HTSL est tout d'abord chauffée au-dessus d'une température T_{z} supérieure aux températures de décomposition des anions des sels afin de former du carbonate de baryum et de l'oxyde de cuivre,
et **en ce que** la couche de précurseur d'HTSL est ensuite portée à une température Tₛ à laquelle le carbonate de baryum et l'oxyde de cuivre forment par une réaction binaire une masse fondue au moins partielle et qui est inférieure à la température à laquelle RE₂BaCuOₓ est formé.

2. Procédé selon la revendication 1, **caractérisé en ce que** de l'eau est utilisée en tant que solvant lors de la fabrication de la solution de précurseur d'HTSL.

3. Procédé selon la revendication 1 ou 2, **caractérisé en ce qu'**une amine, notamment la triéthanolamine ou le tétraacétate d'éthylène-diamine, est ajoutée à la solution de précurseur d'HTSL.

4. Procédé selon l'une quelconque des revendications 1 à 3, **caractérisé en ce que** des nitrates, des tartrates ou des citrates, notamment des acétates, sont utilisés en tant que sels.

5. Procédé selon l'une quelconque des revendications 1 à 4, **caractérisé en ce que** le rapport RE:Ba:Cu dans la solution de précurseur d'HTSL est de 1:1,5 à 2,5:2,5 à 4.

6. Procédé selon l'une quelconque des revendications 1 à 5, **caractérisé en ce que** des nanoparticules oxydiques ou des sels métalliques supplémentaires sont ajoutés à la solution de précurseur d'HTSL.

7. Procédé selon l'une quelconque des revendications 1 à 6, **caractérisé en ce que**, pour le traitement thermique de la couche de précurseur d'HTSL, cette dernière
d) est exposée pendant au moins 25 minutes à la température Tₛ, puis
e) est refroidie à une température Tₐ comprise entre environ 380 °C et 550 °C, de préférence d'environ 400 °C, et cette température Tₐ ± 20 °C est maintenue constante pendant au moins 20 minutes.

8. Procédé selon la revendication 7, **caractérisé en ce que** la couche de précurseur d'HTSL se trouve dans une atmosphère ayant une teneur en oxygène < 20 % pendant qu'elle est exposée à la température Tₛ.

9. Procédé selon la revendication 7 ou 8, **caractérisé en ce que** la couche de précurseur d'HTSL se trouve dans une atmosphère ayant une teneur en oxygène d'au moins 50 % ou de préférence dans une atmosphère d'oxygène pendant qu'elle est exposée à la température Tₐ.

10. Procédé selon l'une quelconque des revendications 1 à 9, **caractérisé en ce que** le pH de la solution de précurseur d'HTSL est ajusté à une valeur comprise entre 3 et 9.

11. Procédé selon l'une quelconque des revendications 1 à 10, **caractérisé en ce que** la solution de précurseur d'HTSL est ajustée à une viscosité d'environ 1 mPas à environ 30 mPas après son application sur le support.

12. Procédé selon l'une quelconque des revendications 1 à 11, **caractérisé en ce que** deux couches ou plus de la solution de précurseur d'HTSL sont appliquées sur le support.

13. Procédé selon l'une quelconque des revendications 1 à 12, **caractérisé en ce que** la couche de précurseur d'HTSL est au moins séchée en surface avant le chauffage à la température T_{z}.

14. Procédé selon l'une quelconque des revendications 1 à 13, **caractérisé en ce qu'**au moins un sel organique et/ou un solvant organique et/ou un complexant organique sont utilisés pour la fabrication de la solution de précurseur d'HTSL afin de former du carbonate de baryum et de l'oxyde de cuivre par décomposition des sels, qui sont portés à une température Tₛ, à laquelle une masse fondue au moins partielle se forme à partir du carbonate de baryum et de l'oxyde de cuivre, dans laquelle le carbonate de baryum se décompose en oxyde de baryum et en dioxyde de carbone.
